**Europäisches Patentamt**

**European Patent Office**

**Office européen des brevets**

(19)

(11) Veröffentlichungsnummer: **0 148 296**
**B1**

(12) **EUROPÄISCHE PATENTSCHRIFT**

(45) Veröffentlichungstag der Patentschrift:
**22.06.88**

(51) Int. Cl.⁴: **G 01 R 19/25**, G 01 L 21/32

(21) Anmeldenummer: **84100138.1**

(22) Anmeldetag: **09.01.84**

(54) Verfahren und Schaltung zur Umwandlung eines Messstromes in eine dem Messstrom proportionale Impulsrate.

(43) Veröffentlichungstag der Anmeldung:
**17.07.85 Patentblatt 85/29**

(45) Bekanntmachung des Hinweises auf die Patenterteilung:
**22.06.88 Patentblatt 88/25**

(84) Benannte Vertragsstaaten:
**CH DE FR GB LI**

(56) Entgegenhaltungen:
**GB - A - 1 400 565**
**US - A - 4 035 720**
**US - A - 4 143 318**
**US - A - 4 144 492**

**FUNKSCHAU, Nr. 24, 1983, München;**
**"Grundschaltungen der Elektronik.**
**Analog/Digital-Umsetzung", Teil 3, Seiten 63, 64, 69, 70**

(73) Patentinhaber: **LEYBOLD AKTIENGESELLSCHAFT,**
**Bonner Str. 504, D-5000 Köln 51 (DE)**

(72) Erfinder: **Heinen, Raymond, Dr., Scheffelstrasse 13,**
**D-5000 Köln 41 (DE)**

(74) Vertreter: **Leineweber, Jürgen, Dipl.-Phys.,**
**Nagelschmiedshütte 8, D-5000 Köln 40 (DE)**

## Beschreibung

Die Erfindung bezieht sich auf ein Verfahren zur Umwandlung eines Messstromes in eine dem Messstrom proportionale Impulsrate sowie auf eine zur Durchführung dieses Verfahrens geeignete Schaltung.

Aus den US-PSen 40 35 720 und 41 43 318 ist es bekannt, einen unbekannten Messstrom dadurch in eine dem Messstrom proportionale Impulsrate umzuwandeln, dass man den unbekannten Strom in eine bekannte Kapazität fliessen lässt, wodurch diese bis zu einer bekannten Spannung aufgeladen wird. Danach wird die Kapazität entladen, so dass der beschriebene Vorgang wiederholt werden kann. Nachteilig an dieser Methode ist, dass die erzielbare Dynamik, die Messgenauigkeit und auch die Messgeschwindigkeit von der Wahl der Kapazität abhängen. Wird z.B. eine relativ grosse bekannte Kapazität gewählt, dann können Eingangsströme bis hinunter zu einigen pA nicht mehr verarbeitet werden, da es unzumutbar lange dauert, bis die Kapazität aufgeladen ist. Wird die Kapazität ausreichend klein gewählt (z.B. einige pF), dann haben die Eigenschaften einer solchen Kapazität Einfluss auf die Messgenauigkeit. Normalerweise sind Kapazitäten dieser Grössenordnung instabil, d.h., das die Aufladungen nicht immer gleichmässig sind. Stabile Ausführungsformen von Kapazitäten dieser Grössenordnung sind nur mit relativ hohem Aufwand erzielbar.

Um diese geschilderten Nachteile zu entschärfen, werden in den genannten US-Patentschriften Sensormittel für den Wert des Messstromes vorgeschlagen, um in Abhängigkeit des Messstromes den Schwellenwert, bei dem die Kapazität entladen wird, verändern zu können. Diese Massnahmen erfordern einen zusätzlichen Schaltungsaufwand. Ausserdem werden die Schwierigkeiten bei geringen Messströmen nicht beseitigt, da nach wie vor die Kapazität Einfluss auf das Messverfahren hat

Bei Ionisationsvakuummetern, Massenspektrometern und dergleichen ist es häufig erforderlich, Messströme im Bereich von $10^{-3}$ bis zu $10^{-12}$ A verarbeiten zu müssen. Ströme dieser Grössenordnung werden bisher meist mit Verstärkern in Spannungen umgesetzt und dann gemessen. Da eine Spannung jedoch nicht über neun Zehnerpotenzen in einem Bereich exakt verarbeitet werden kann, werden die Ströme entweder bei der Umwandlung logarithmiert oder in mehrere Spannungsbereiche umschaltbar umgeformt. Die Auswertung des Ausgangssignales kann durch Anzeige mit einem analogen Instrument oder durch Umsetzung in einen Zahlenwert und digitale Anzeige desselben geschehen. Bei der digitalen Auswertung des Signals stellt jede der beiden genannten Möglichkeiten der Strom-Spannungs-Umwandlung einen Umweg mit zusätzlichen Fehlerquellen und Kosten dar.

Weiterhin gehören zum Stand der Technik Schaltungen, die in dem Artikel «Funkschau», Nr. 24/1983, Seiten 63, 64, 69, 70, beschrieben sind.

Unter anderem ist darin ein Zweirampen-A/D-Umsetzer der gattungsgemässen Art offenbart, bei dem von einer Spannungsquelle $I_{ref}$ gebildete Kompensationsmittel vorgesehen sind. Wechselweise wird der Knotenpunkt mit dem Messeingang und mit dem Referenzeingang verbunden. Der Messbereich einer Schaltung dieser Art hängt ebenfalls von der Grösse der Kapazität des Integrators ab, so dass die erzielbare Dynamik relativ klein ist.

Der vorliegenden Erfindung liegt die Aufgabe zugrunde, ein Verfahren zur Umwandlung eines Messstromes in eine dem Messstrom proportionale Impulsrate vorzuschlagen, welches sich durch einen grossen Dynamikbereich und eine hohe Linearität auszeichnet.

Erfindungsgemäss wird diese Aufgabe dadurch gelöst, dass der Messstrom $i_x$ durch einen Strom kompensiert wird, der aus kleinen Ladungen gleicher Grösse und dem Messstrom entgegengesetzter Polarität besteht, und dass die pro Zeiteinheit benötigten Ladungen die gewünschte Impulsrate bilden. Der besondere Vorteil dieses Verfahrens liegt darin, dass es – bei ausreichend kleinen Ladungsmengen – unempfindlich ist gegenüber Veränderungen der Kapazität und der Schwellenwerte. Es kommt nur darauf an, die Grösse der erzeugten Kompensationsladungen zu kennen. Kleine Ladungsmengen – z.B. in der Grössenordnung von einigen Picoamperesekunden – können mit grosser Genauigkeit hergestellt werden, so dass auch bei kleinen Strömen ($10^{-9}$ bis $10^{-12}$ A) eine hohe Messgenauigkeit eingehalten werden kann. Desweiteren zeichnet sich das erfindungsgemässe Verfahren durch einen hohen Dynamikbereich und eine hohe Linearität aus. Es kann grundsätzlich zur Messung von Strömen beider Polaritäten eingesetzt werden und eignet sich deshalb insbesondere zur Messung der Ausgangssignale von Ionisationskammern mit und ohne Sekundärelektronen-Vervielfacher, wie sie in Vakuummetern und Quadrupolen verwendet werden. Das Ausgangssignal ist eine Frequenz, die sich digital gut auswerten lässt.

Wesentlich an dem erfindungsgemässen Verfahren ist, dass ein Gleichgewicht zwischen einem gleichmässig fliessenden, zu messenden Strom und einem pulsierend fliessenden bekannten Strom entgegengesetzter Richtung herbeigeführt wird. Hieraus ergeben sich die Vorteile hinsichtlich der Linearität und der Toleranzempfindlichkeit.

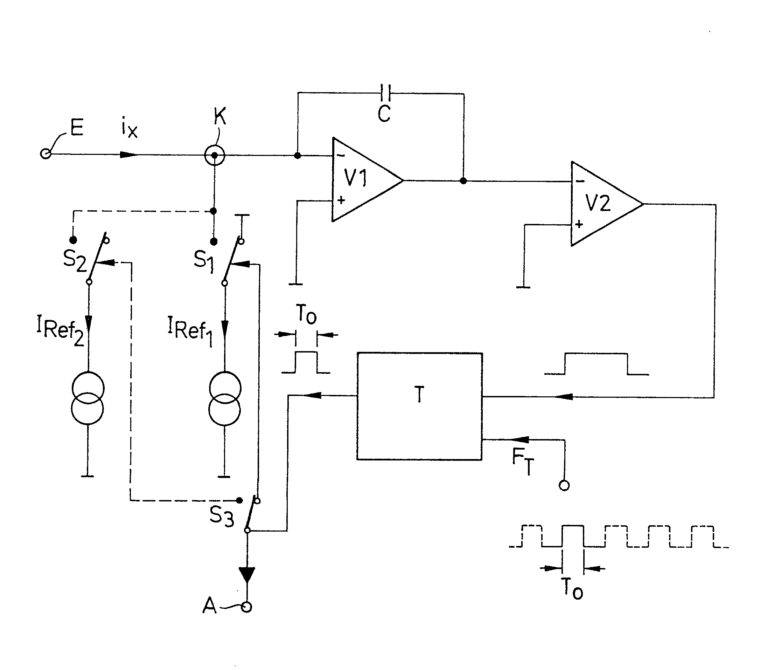

Weitere Vorteile und Einzelheiten der Erfindung sollen anhand eines in der Figur dargestellten Blockschaltbildes erläutert werden.

Der zu messende Strom $i_x$ wird der Schaltung E zugeführt und fliesst in den Knotenpunkt K, an den der invertierende Eingang des Verstärkers V1, der Kondensator C und der Schalter $S_1$ angeschlossen sind. Der Schalter $S_1$ ist zunächst geöffnet. Da der Verstärker V1 und der Kondensator C so verschaltet sind, dass sie einen Integrator bilden, bewirkt der Messstrom, dass die Ausgangs-

spannung $U_a$ des Verstärkers V1 nach der Beziehung

$$U_a(t) = \frac{-i_x}{c} t$$

ihren Anfangswert verändert. Sie läuft abwärts bei einem positiven Eingangsstrom bzw. aufwärts bei einem negativen Eingangsstrom.

Unter- bzw. überschreitet sie dabei am Eingang des Verstärkers V2 den Wert 0 (oder einen anderen konstanten Wert), so gibt der als Komparator verschaltete Verstärker V2 an die Torschaltung T einen Impuls, welcher genau ein Taktsignal der Dauer $T_0$ durch die Torschaltung T passieren lässt. Dieser Impuls löst das Schliessen des Schalters $S_1$ für die Dauer von $T_0$ aus.

Die Stromquelle $I_{Ref1}$ erzeugt einen Strom bekannter Amplitude, jedoch mit einer zu $i_x$ entgegengesetzten Polarität. Somit speist die Stromquelle $I_{Ref1}$ über den Schalter $S_1$ mit jedem Taktsignal eine Ladung der Grösse

$$Q_o = -I_{Ref} \cdot T_o$$

in den Knoten K, in welchen auch $i_x$ fliesst.

Um den Strom $i_x$ aufzuwiegen, benötigt man

$$n = \frac{i_x}{Q_o}$$

Impulse pro Zeiteinheit. Der Strom $i_x$ kann deshalb aufgewogen werden, solange der Messstrom $i_x$ mit 100% der Taktimpulse noch kompensierbar ist, d.h., solange die Bedingung

$$i_x < F_T \cdot Q_o$$

eingehalten wird. Ändert sich der Messstrom $i_x$, so ändert sich auch die Häufigkeit der Auslösung einer Kompensationsladung $Q_o$, so dass eine ständige Kompensation des Messstromes mit den Impulsen erreicht wird.

Veränderungen der Kapazität C haben dabei in weiten Grenzen keinen Einfluss auf den Zusammenhang zwischen der Impulszahl n und dem Strom $i_x$. Zur Bestimmung des quantitativen Zusammenhangs zwischen $i_x$ und n muss erreicht werden, dass die Summe aller auf den Eingangsknoten K zufliessenden Ströme den Wert 0 hat.

Der Eingangsstrom des Verstärkers V1 soll vernachlässigbar gegen $i_x$ sein. Der Strom in den Kondensator C ist im zeitlichen Mittel 0. Somit gilt die Beziehung

$$i_x = n \cdot Q_o = n \cdot I_{Ref} \cdot T_o.$$

Bei bekanntem Strom $I_{Ref1}$ und bekannter Plusdauer $T_o$ kann daher aus der Pluszahl n der Strom $i_x$ quantitativ bestimmt werden. Die Plusrate kann am Ausgang A abgenommen werden.

Neben der Stromquelle $I_{Ref1}$ ist eine weitere Stromquelle $I_{ref2}$ vorgesehen. Der Stromquelle $I_{ref2}$ ist der Schalter $S_2$ zugeordnet, mit der die Stromquelle $I_{ref2}$ in Abhängigkeit von den von der Torschaltung T gelieferten Impulsen mit den Knotenpunkt K verbunden werden kann. Mittels des Schalters $S_3$ können die Impulse der Torschaltung T entweder dem Schalter $S_1$ oder dem Schalter $S_2$ zugeführt werden.

Die zweite Stromquelle $I_{Ref2}$ kann entweder einen grösseren oder kleineren Strom als $I_{Ref1}$ liefern, so dass die Dynamik des Systems erhöht werden kann; die Stromquelle $I_{Ref2}$ kann aber auch einen Strom liefern, der gegenüber dem Strom von $I_{Ref1}$ eine umgekehrte Polarität hat, so dass Messströme $i_x$ mit beiden Vorzeichen verarbeitet werden können. Natürlich ist es auch möglich, mehr als zwei Referenzstromquellen $I_{Ref}$ vorzusehen.

Zur Erzielung eines gewünschten Umsetzfaktors, z.B. zwischen 0,1 und 1 Hz/pA ist es erforderlich, Kompensationsladungsmengen von 1 bis 10 pAs genau genug dosieren zu können. Dies wird erfindungsgemäss dadurch erreicht, dass Ströme im Bereich einiger nA für Zeiten von weniger als 1 ms in den Knotenpunkt geleitet werden. Da sich das Potential des Schalters $S_1$ (bzw. $S_2$) dabei nicht verändert, entstehen auch keine durch das Schalten bedingte Ladungsverschiebungen. Die Schalter $S_1$ und $S_2$ bestehen deshalb vorzugsweise jeweils aus einem Transistorpaar (Bipolartransistor, Sperrschicht-Feldeffekt-Transistor oder Isolierschicht-Feldeffekt-Transistor).

Die beschriebene Schaltung zur Erzeugung von Kompenastionsladungen gestattet den Wechsel des Messbereichs in der Zeit aufeinanderfolgender Pulse, die vorzugsweise ca. 50 µs lang sind. Somit kann ohne störende Umschaltzeit ein Dynamikbereich des Messstromes von bis zu 9 Dekaden erreicht werden.

Als Integratoren können geeignte integrierte Operationsverstärker verwendet werden. Die Detektorfunktion wird ausreichend durch einen beliebigen Schmitt-Trigger erfüllt. Die Kapazität muss eine leckstromarme Ausführung, vorzugsweise mit Polysterol-Dielektrikum sein.

## Patentansprüche

1. Verfahren zur Umwandlung eines Messstromes in eine dem Messstrom proportionale Impulsrate, dadurch gekennzeichnet, dass der Messstrom ($i_x$) durch einen Strom kompensiert wird, der aus kleinen Ladungen gleicher Grösse und dem Messstrom entgegengesetzter Polarität besteht, und dass die pro Zeiteinheit benötigten Ladungen die gewünschte Impulsrate bilden.

2. Schaltung zur Umwandlung eines Messstromes in eine dem Messstrom proportionale Impulsrate mit einem Integrator, einem Komparator sowie einem Knotenpunkt (K), an den der Eingang (E) für die Zuführung des Messstromes ($i_x$), der Integrator und Kompensationsschaltmittel angeschlossen sind, dadurch gekennzeichnet, dass an den Knotenpunkt ein Schalter ($S_1$, $S_2$) angeschlossen ist, der mittels einer dem Komparator nachgeordneten Torschaltung (T) betätigbar ist und über den eine Stromquelle ($I_{Ref1}$, $I_{Ref2}$) mit dem Knotenpunkt (K) verbindbar ist.

3. Schaltung nach Anspruch 2, dadurch gekennzeichnet, dass der Integrator von einem Verstärker (V1) und einem Kondensator (C) und der Komparator von einem weiteren Verstärker (V2) gebildet werden.

4. Schaltung nach Anspruch 2 oder 3, dadurch gekennzeichnet, dass zwei oder mehr Schalter ($S_1$, $S_2$) vorgesehen sind, über die jeweils verschiedene Stromquellen ($I_{Ref1}$, $I_{Ref2}$) mit dem Knotenpunkt (K) verbindbar sind.

5. Schaltung nach Anspruch 6 oder 7, dadurch gekennzeichnet, dass zwei Stromquellen ($I_{Ref1}$, $I_{Ref2}$) und diesen zugeordnete Schalter ($S_1$, $S_2$) vorgesehen sind, die wahlweise mit der Torschaltung (T) über einen Schalter ($S_3$) zur Bildung der Kompensationsladungsmengen verbindbar sind.

6. Schaltung nach einem der Ansprüche 2 bis 5, dadurch gekennzeichnet, dass die Schalter ($S_1$, $S_2$), von einem Transistorpaar gebildet werden.

7. Ionisationsvakuummeter, gekennzeichnet durch eine Schaltung nach einem der Patentansprüche 2 bis 6.

**Revendications**

1. Procédé pour convertir un courant de mesure en un taux ou fréquence d'impulsions qui est proportionnel au courant de mesure, caractérisé en ce que l'on compense le courant de mesure ($i_x$) par un courant constitué de petites charges de même grandeur et de polarité contraire au courant de mesure et que les charges nécessaires par unité de temps forment le taux d'impulsions désiré.

2. Circuit pour convertir un courant de mesure en un taux ou fréquence d'impulsions proportionnel au courant de mesure, comprenant un intégrateur, un comparateur, ainsi qu'un nœud (K) auquel sont connectés l'entrée (E) pour l'application du courant de mesure ($i_x$), l'intégrateur et des moyens de compensation faisant partie du circuit caractérisé par le raccordement au nœud d'un interrupteur ($S_1$, $S_2$), qui peut être commandé au moyen d'un circuit de porte (T) prévu à la suite du comparateur, l'interrupteur étant raccordable au nœud (K) à travers une source de courant ($I_{Ref1}$, $I_{Ref2}$).

3. Circuit selon la revendication 2, caractérisé en ce que l'intégrateur est formé par un amplificateur (V1) et un condensateur (C) et que le comparateur est formé par un amplificateur supplémentaire (V2).

4. Circuit selon la revendication 2 ou 3, caractérisé en ce qu'il comprend deux ou davantage d'interrupteurs ($S_1$, $S_2$), à travers chacun desquels différentes sources de courant ($I_{Ref1}$, $I_{Ref2}$) peuvent être raccordées au nœud (K).

5. Circuit selon la revendication 3 ou 4, caractérisé en ce qu'il comprend deux sources de courant ($I_{Ref1}$, $I_{Ref2}$), et des interrupteurs ($S_1$, $S_2$) coordonnés à celles-ci et qui peuvent être connectés sélectivement au circuit de porte (T) au moyen d'un inverseur ($S_3$) pour la formation des quantités de charge de compensation.

6. Circuit selon l'une quelconque 2 à 5, caractérisé en ce que les interrupteurs ($S_1$, $S_2$) sont formés par un paire de transistors.

7. Vacuomètre à ionisation, caractérisé par un circuit selon l'une quelconque des revendications 2 à 6.

**Claims**

1. A method for converting a measuring current into a pulse rate proportional to the measuring current, characterized in that the measuring current ($i_x$) is compensated by a current which consists of small charges of the same size and opposite polarity to the measuring current, and in that the charges necessary per unit time form the desired pulse rate.

2. A circuit for converting a measuring current into a pulse rate proportional to the measuring current, comprising an integrator, a comparator and a nodal point (K), to which the input (E) for the supply of the measuring current ($i_x$) the integrator and compensation switching means are connected, characterized in that a switch ($S_1$, $S_2$) is connected to the nodal point which is operable by means of a gate circuit (T) arranged downstream of the comparator and is connectable by means of the one current source ($I_{Ref1}$, $I_{Ref2}$) with the nodal point (K).

3. A circuit according to claim 2, characterized in that the integrator is formed of an amplifier (V1) and a capacitor (C) and the comparator is formed of another amplifier (V2).

4. A circuit according to claim 2 or claim 3, characterized in that two or more switches ($S_1$, $S_2$) are provided, by means of which the different current sources ($I_{Ref1}$, $I_{Ref2}$) may be connected to the nodal point (K).

5. A circuit according to claim 6 or claim 7, characterized in that two current sources ($I_{Ref1}$, $I_{Ref2}$) and switches ($S_1$, $S_2$) associated therewith are provided, which are selectively connectable with the gate circuit (T) via a switch ($S_3$) to generate the compensation charging quantities.

6. A circuit according to any one of claims 2 to 5, characterized in that the switches ($S_1$, $S_2$) are formed of pairs of transistors.

7. An ionization vauum gauge, characterized by a circuit according to any one of claims 2 to 6.